# EUROPEAN PATENT APPLICATION

(11) **EP 4 693 808 A1**
(43) Date of publication of application: **11.02.2026**
(21) Application number: 25194406.2
(22) Date of filing: 06.08.2025
(51) Int. Cl.: H02J 7/00, H02H 7/18, H01M 10/42

(54) **BATTERY DEVICE AND OPERATING METHOD THEREOF**

(30) Priority: 08.08.2024 KR 20240106121
(71) Applicant: SAMSUNG SDI CO., LTD., Yongin-si, Gyeonggi-do 17084 (KR)
(72) Inventor: JIN, Kyong Pil, 16678 Suwon-si (KR); KIM, Ha Neul, 16678 Suwon-si (KR); JEONG, Yong Jun, 16678 Suwon-si (KR)
(74) Representative: Marks & Clerk LLP

(57) **Abstract**

A battery device includes: a main processor (100) to monitor a voltage of a battery (BAT) in a wake-up state, and perform a protection operation of a battery pack depending on a monitoring result; and a sub-processor (600) to monitor the voltage of the battery (BAT) in a sleep state of the main processor (100), and generate a wake-up signal for waking up the main processor (100) when an abnormality occurs in the voltage of the battery (BAT) monitored by the sub-processor (600). The main processor (100) is to be woken up by the wake-up signal, monitor the voltage of the battery (BAT), determine a current status of the battery pack depending on the voltage of the battery (BAT) monitored by the main processor (100), and perform the protection operation depending on a determination result.

## Description

### BACKGROUND

### 1. Field

Aspects of embodiments of the present disclosure relate to a battery device having a battery protection function, and an operating method of the battery device.

### 2. Description of the Related Art

Secondary batteries are batteries that can be charged and discharged, unlike primary batteries that cannot be recharged. Low-capacity secondary batteries are used in small portable electronic devices such as smartphones, feature phones, laptop computers, digital cameras, and camcorders, and high-capacity secondary batteries are widely used as motor driving power sources, power storage batteries, and the like in hybrid vehicles, electric vehicles, and the like. The secondary batteries include an electrode assembly composed of a positive electrode and a negative electrode, a case that accommodates the electrode assembly, and an electrode terminal connected to the electrode assembly.

The above information disclosed in this Background section is for enhancement of understanding of the background of the present disclosure, and therefore, it may contain information that does not constitute related (or prior) art.

### SUMMARY

Recently, cases of arbitrarily disassembling a finished battery pack and replacing battery cells, or recycling a battery management system (BMS) by separating the BMS mounted on the battery pack and mounting the BMS on another battery pack are increasing. Because such disassembly, modification, and reassembly of the battery pack may directly lead to problems, such as a battery pack malfunction and subsequent ignition, the disassembly, modification, and reassembly of the battery pack may be strictly prohibited.

Further, a charge path through which a charge current supplied to the battery pack flows, and a discharge path through which a discharge current drawn from the battery pack flows may be separated from each other depending on a product group to which the battery pack is applied. When the battery pack is shut down, the BMS is also present in a shutdown state (or a sleep state), and accordingly, because the BMS may not recognize the charging of the battery pack through the discharge path in the shutdown state of the battery pack, a phenomenon in which a battery is overcharged may occur, and thus, a safety accident, such as ignition of the battery pack, may be caused.

Embodiments of the present disclosure may be directed to a battery device and an operating method of the battery device for detecting a situation of a disassembly, a modification, and a reassembly of a battery pack performed in a shutdown state of the battery pack, detecting a situation of charging the battery pack through a discharge path, and performing a consequent protection operation to secure safety of the battery pack.

However, the present disclosure is not limited to the above aspects and features. The above and additional aspects and features will be set forth, in part, in the description that follows, and in part, may be apparent from the description, or may be learned by practicing one or more of the presented embodiments of the present disclosure.

According to one or more embodiments of the present disclosure, a battery device includes: a main processor configured to monitor a voltage of a battery in a wake-up state, and perform a protection operation of a battery pack depending on a monitoring result; and a sub-processor configured to monitor the voltage of the battery in a sleep state of the main processor, and generate a wake-up signal for waking up the main processor when an abnormality occurs in the voltage of the battery monitored by the sub-processor. The main processor is configured to be woken up by the wake-up signal, monitor the voltage of the battery, determine a current status of the battery pack depending on the voltage of the battery monitored by the main processor, and perform the protection operation depending on a determination result.

In an embodiment, the sub-processor may be configured to generate an abnormal state signal indicating that the voltage of the battery is in an abnormal state along with the wake-up signal when the abnormality occurs in the voltage of the battery. The main processor may be configured to be woken up by the wake-up signal, and monitor the voltage of the battery after recognizing that the voltage of the battery is in the abnormal state through the abnormal state signal.

In an embodiment, when a current monitored voltage of the battery satisfies a first voltage condition related to a voltage change, the main processor may be configured to determine that the battery pack is in a disassembled state.

In an embodiment, when it is determined that the battery pack is in the disassembled state as the current monitored voltage of the battery satisfies the first voltage condition, the main processor may be further configured to first verify a risk of the battery pack in the disassembled state using battery management information for managing the battery pack, and then determine whether or not to perform the protection operation of the battery depending on a verification result.

In an embodiment, the battery management information may include manufacturing date information of the battery pack. The main processor may be configured to determine that the battery pack in the disassembled state is in a dangerous state. The main processor may be configured to perform the protection operation of the battery pack when the battery management information is already stored.

In an embodiment, the battery device may further include a charge/discharge path for supplying a charge current to the battery and drawing a discharge current from the battery. The charge/discharge path may include a first protective element configured to block a current flow. When the protection operation of the battery pack is performed, the main processor may be configured to block the current flow on the charge/discharge path through the first protective element.

In an embodiment, the battery device may further include: a charge path branching from the charge/discharge path to supply a flow of the charge current to the battery. The battery device may include a discharge path branching from the charge/discharge path to draw a flow of the discharge current from the battery. The main processor may be configured to monitor the voltage of the battery after recognizing that the voltage of the battery is in the abnormal state through the abnormal state signal. The main processor may be configured to determine that the battery is being charged by the charge current supplied through the discharge path when the current monitored voltage of the battery satisfies a second voltage condition related to an overcharge state of the battery.

In an embodiment, when it is determined that the battery is being charged by the charge current supplied through the discharge path as the current monitored voltage of the battery satisfies the second voltage condition, the main processor may be configured to block the current flow on the charge/discharge path through the first protective element.

In an embodiment, the battery device may further include a signal arbitration circuit configured to arbitrate transmission of the wake-up signal and the abnormal state signal from the sub-processor to the main processor.

In an embodiment, the signal arbitration circuit may include a base path, and first and second branch paths branching from the base path. A base current output from the sub-processor may be configured to flow through the base path to form the wake-up signal and the abnormal state signal. The wake-up signal may be formed by a first branch current branching from the base current, and may be configured to flow in the first branch path. The abnormal state signal may be formed by a second branch current branching from the base current, and may be configured to flow in the second branch path.

In an embodiment, the battery device may further include a charge path configured to flow the charge current supplied to the battery, the charge path including a charge control switch configured to regulate a flow of the charge current, and a second protective element configured to block the flow of the charge current when a defect occurs in the charge control switch. The main processor may be configured to operate the second protective element through a blocking signal to block a current flow on the charge path in the wake-up state when the defect occurs in the charge control switch and the battery is in an overcharge state.

In an embodiment, the signal arbitration circuit may further include a third branch path branching from the base path, the third branch path being configured to flow a third branch current branching from the base current. The blocking signal and the third branch current may be configured to be combined with each other at the same node to operate the second protective element.

According to one or more embodiments of the present disclosure, a method of operating a battery device including a sub-processor and a main processor, includes: monitoring, by the sub-processor, a voltage of a battery when the main processor is in a sleep state; generating, by the sub-processor, a wake-up signal for waking up the main processor when an abnormality occurs in the voltage of the battery monitored by the sub-processor; monitoring, by the main processor, the voltage of the battery after being woken up by the wake-up signal; determining, by the main processor, a current status of a battery pack according to the voltage of the battery monitored by the main processor; and performing, by the main processor, a protection operation depending on a determination result of the current status of the battery pack.

In an embodiment, in the generating, the sub-processor may form an abnormal state signal indicating that the voltage of the battery is in an abnormal state along with the wake-up signal when the abnormality occurs in the voltage of the battery. In the monitoring by the main processor, the main processor may be woken up by the wake-up signal and monitor the voltage of the battery after recognizing that the voltage of the battery is in the abnormal state through the abnormal state signal.

In an embodiment, in the determining, when a current voltage of the battery monitored by the main processor satisfies a first voltage condition related to a voltage change, the main processor may determine that the battery pack is in a disassembled state.

In an embodiment, in the performing, when it is determined that the battery pack is in the disassembled state as the current voltage of the battery satisfies the first voltage condition, the main processor may first verify a risk of the battery pack in the disassembled state using battery management information for managing the battery pack, and then may determine whether or not to perform the protection operation of the battery depending on a verification result.

In an embodiment, the battery management information may include manufacturing date information of the battery pack. In the performing, the main processor may determine that the battery pack in the disassembled state is in a dangerous state, and may perform the protection operation of the battery pack when the battery management information is already stored.

In an embodiment, the battery device may further include a charge/discharge path for supplying a charge current to the battery and drawing a discharge current from the battery. The charge/discharge path may include a first protective element for blocking a current flow; and in the performing, the main processor may block the current flow on the charge/discharge path through the first protective element.

In an embodiment, the battery device may further include a charge path branching from the charge/discharge path to flow a supply of the charge current to the battery. The battery device may include a discharge path branching from the charge/discharge path to flow a draw of the discharge current from the battery. In the determining, the main processor may monitor the voltage of the battery after recognizing that the voltage of the battery is in the abnormal state through the abnormal state signal, and may determine that the battery is being charged by the charge current supplied through the discharge path when the monitored current voltage of the battery satisfies a second voltage condition related to an overcharge state of the battery.

In an embodiment, in the performing, when it is determined that the battery is being charged by the charge current supplied through the discharge path as the current voltage of the battery satisfies the second voltage condition, the main processor may block the current flow on the charge/discharge path through the first protective element.

However, the present disclosure is not limited to the above aspects and features, and the above and additional aspects and features will be set forth, in part, in the detailed description that follows with reference to the drawings, and in part, may be apparent therefrom, or may be learned by practicing one or more of the presented embodiments of the present disclosure.

At least some of the above and other features of the invention are set out in the claims.

### BRIEF DESCRIPTION OF THE DRAWINGS

The above and other aspects and features of the present disclosure will be more clearly understood from the following detailed description of the illustrative, non-limiting embodiments with reference to the accompanying drawings, in which:
FIG. 1 illustrates an example of a battery management system (BMS) circuit structure to which a battery device may be applied according to an embodiment of the present disclosure;
FIG. 2 illustrates a circuit structure of a battery device according to an embodiment of the present disclosure; and
FIG. 3 is a flow chart of a method of operating a battery device according to an embodiment of the present disclosure.

### DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

Further, as would be understood by a person having ordinary skill in the art, in view of the present disclosure in its entirety, each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner, unless otherwise stated or implied.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Further, it should be expected that the shapes shown in the figures may vary in practice depending, for example, on tolerances and/or manufacturing techniques. Accordingly, the embodiments of the present disclosure should not be construed as being limited to the specific shapes shown in the figures, and should be construed considering changes in shapes that may occur, for example, as a result of manufacturing. As such, the shapes shown in the drawings may not depict the actual shapes of areas of the device, and the present disclosure is not limited thereto.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein.

References to two compared elements, features, and the like as being "the same " as each other may mean that they are "substantially the same" as each other. Thus, the phrase "substantially the same" may include a case having a deviation or variation that is considered low in the art, for example, such as a deviation or variation of 5% or less. In addition, when a certain parameter is referred to as being uniform in a given region, it may mean that it is uniform in terms of an average.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

### 1. Battery management system (BMS) circuit structure

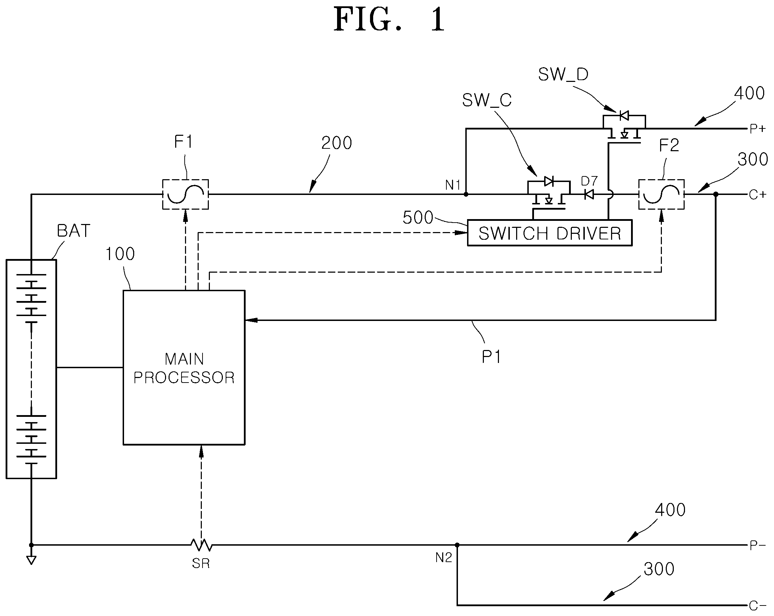

FIG. 1 illustrates an example of a BMS circuit structure to which a battery device may be applied according to an embodiment of the present disclosure.

Referring to FIG. 1, the circuit diagram in FIG. 1 corresponds to a BMS circuit structure, which may be used for implementing the battery device according to some embodiments described in more detail below, and constitutes a portion of the battery device. A battery BAT may refer to a battery cell or a battery module, and a voltage of the battery BAT monitored by a main processor 100 and a sub-processor 600 may refer to a voltage of the battery cell or a voltage of the battery module.

The BMS may include the main processor 100, a charge/discharge path 200, a charge path 300, a discharge path 400, a shunt resistor SR, and a switch driver 500. As used herein, the term "path" may be defined as including one or more elements (e.g., a switch, a fuse, a resistor, a diode, and/or the like) connected onto the corresponding path.

The main processor 100 may monitor a state of the battery BAT, and may perform a battery cell control operation depending on a monitoring result. For example, the main processor 100 may monitor a voltage, a current, a temperature, and a state of charge (SOC) of the battery BAT, and may perform control operations, such as a balancing control, a temperature control, and a charge/discharge control, of the battery BAT, or may perform a protection operation, such as a switch control for preventing or substantially preventing overdischarging or overcharging, depending on the monitoring result. The main processor 100 may include an analog front end integrated circuit (AFE IC) and a microcontroller unit (MCU) of the BMS. For example, FIG. 1 illustrates a structure in which the AFE IC and the MCU of the BMS are integrally implemented with each other as one main processor 100, but in other embodiments, the AFE IC and the MCU may be separately implemented as two separate processors.

The charge/discharge path 200 may be a path for supplying a charge current to the battery BAT, and drawing a discharge current from the battery BAT. In other words, the charge current may be supplied to the battery BAT via the charge/discharge path 200 when the battery BAT is charged, and the discharge current may be supplied to a load via the charge/discharge path 200 when the battery BAT is discharged. In FIG. 1, a path connected to a first node N1, a first protective element F1, the battery BAT, the shunt resistor SR, and a second node N2 is defined as the charge/discharge path 200. The first and second nodes N1 and N2 correspond to nodes to which the charge path 300 and discharge path 400 to be described in more detail below are connected in common.

As shown in FIG. 1, the charge/discharge path 200 may include the first protective element F1, and the first protective element F1 may be implemented as a self-control protector (SCP) fuse for blocking a current flow on the charge/discharge path 200. The main processor 100 may operate (e.g., may fuse) the first protective element F1 when an abnormality in the battery pack occurs (e.g., when an inner wire of the battery pack is short-circuited due to an excessive power consumption of the battery pack, and thus, an overvoltage of the battery cell occurs) so that the current flow on the charge/discharge path 200 may be blocked (hereinafter, the term "an operation of the protective element" is defined as "opening of the path including the protective element" or "fusing of the fuse").

The charge path 300 may be formed by branching from the charge/discharge path 200, and may correspond to a path through which the charge current supplied to the battery cell for charging the battery cell flows. As used herein, a path that connects a charging positive electrode terminal C+ and the first node N1 to which an external charger is connected and a path that connects a charging negative electrode terminal C- and the second node N2 to which the external charger is connected are defined as the charge path 300 in FIG. 1. A signal path P1 that branches from a node of the charging positive electrode terminal C+ on the charge path 300 and is connected to the main processor 100 may be provided in the BMS. Accordingly, the main processor 100 in a sleep state while in a shutdown state of the battery pack may wake up based on a charge voltage signal received through the signal path P1 when the external charger is connected.

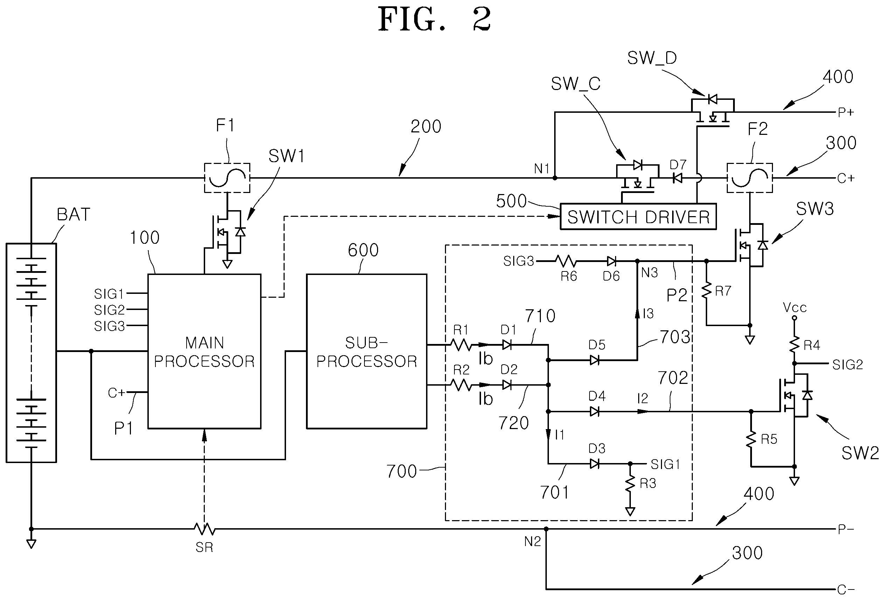

As shown in FIG. 1, a charge control switch SW_C, a diode D7, and a second protective element F2 may be provided in the charge path 300. The charge control switch SW_C may be implemented as a FET for regulating the flow of the charge current on the charge path 300 by performing an on/off operation under the control of the main processor 100 and the switch driver 500. The second protective element F2 may be implemented as an SCP fuse for blocking the flow of the charge current on the charge path 300 when a defect (e.g., a FET short circuit) occurs in the charge control switch SW_C. The main processor 100 may control the on/off of the charge control switch SW_C through the switch driver 500 to regulate the flow of the charge current on the charge path 300, and may operate (e.g., may fuse) the second protective element F2 through a blocking signal SIG3 (e.g., see FIG. 2) to block the current flow on the charge path 300 when the short circuit defect of the charge control switch SW_C occurs.

The discharge path 400 may be formed by branching from the charge/discharge path 200, and may correspond to a path through which the discharge current drawn from the battery flows. As used herein, in FIG. 1, a path that connects a positive electrode terminal P+ of the battery pack and the first node N1 to each other and a path that connects a negative electrode terminal P- of the battery pack and the second node N2 to each other are defined as the discharge path 400.

As shown in FIG. 1, a discharge control switch SW_D may be provided in the discharge path 400. The discharge control switch SW_D may be implemented as a FET for regulating a flow of the discharge current on the discharge path 400 by performing an on/off operation under the control of the main processor 100 and the switch driver 500. The main processor 100 may control the on/off of the discharge control switch SW_D through the switch driver 500 to regulate the flow of the discharge current on the discharge path 400.

The shunt resistor SR may function as a resistor element connected to the charge/discharge path 200 to detect an overcurrent flowing in the battery BAT, and the switch driver 500 may correspond to a gate driver that controls the on-off operations of the charge control switch SW_C and the discharge control switch SW_D under the control of the main processor 100. Accordingly, the main processor 100 may operate to prevent or substantially prevent damage to the battery BAT due to the overcurrent by detecting a state in which the overcurrent flows in the battery BAT through the shunt resistor SR, and controlling the switch driver 500 to turn off the charge control switch SW_C or the discharge control switch SW_D.

A shutdown mode is applied to the battery pack to which the BMS of the above-described circuit structure is applied. In more detail, when the battery pack is not used for a long period of time, because the battery cell applied to the battery pack is discharged by itself due to a self-consumption current of the BMS, limitations in the use of the battery pack may be caused. In order to prevent such limitations in the use in the future due to self-discharging of the battery pack, when a limit time (e.g., a predefined or predetermined limit time) elapses from a time of the last use of the battery pack or when the voltage of the battery pack is formed below a limit voltage (e.g., a predefined or predetermined limit voltage), the battery pack enters the shutdown state and the main processor 100 of the BMS also enters the sleep state, so that the operation of the battery pack stops. In the shutdown state of the battery pack, all operations of the BMS, for example, such as monitoring operations for the voltage, current, temperature, and SOC of the battery cell, control operations, such as a balancing control, a temperature control, and a charge/discharge control of the battery cell, and protection operations for preventing or substantially preventing overdischarging or overcharging, such as a switch control and a fuse control, are stopped. In the shutdown state of the battery pack, the switch and the protective element also maintain an off state.

Because all operations of the BMS are stopped in the shutdown state of the battery pack, the battery pack becomes usable when the battery pack is disassembled and reassembled in the shutdown state of the battery pack and then the battery pack is switched to an active state again. When the BMS is recycled by extracting only the BMS and transferring the BMS to another battery pack after the battery pack is disassembled in the shutdown state, when a usable current of a new battery cell applied to a new battery pack is smaller than a usable current of an original battery cell applied to an original battery pack, because the BMS may not normally perform an overcurrent protection (OCP) operation for the new battery pack, and thus, may not protect the new battery cell from a major damage, a safety accident, such as ignition of the new battery pack, may be caused as a result.

Further, in the case of the battery pack shown in FIG. 1 in which the charge path 300 and the discharge path 400 are independently configured, in the wake-up state of the main processor 100 of the BMS, as the main processor 100 turns off the discharge control switch SW_D or operates the first protective element F1 by recognizing a situation in which the battery pack is being charged through the discharge path 400, the battery pack may be prevented from being charged through the discharge path 400. However, because the main processor 100 is also present in the sleep state while in the shutdown state of the battery pack, the charging of the battery pack through the discharge path 400 in the shutdown state of the battery pack may not be recognized by the main processor 100, and thus, a situation in which the battery BAT is overcharged may occur. Accordingly, a safety accident, such as ignition of the battery pack, may be caused.

In the shutdown state of the battery pack and in the sleep state of the main processor 100, according to some embodiments, a configuration that allows the main processor 100 to recognize i) a disassembly situation of the battery pack, and ii) a situation of charging the battery pack through the discharge path 400, and performs a consequent protection operation may be provided, as will be described in more detail below with reference to FIG. 2.

### 2. Battery device

FIG. 2 illustrates a circuit structure of a battery device according to an embodiment of the present disclosure. In FIG. 2, the same reference numerals are used to denote the same or substantially the same components as those described above with reference to FIG. 1.

Referring to FIG. 2, in an embodiment, a sub-processor 600 that functions as a secondary IC for waking up the main processor 100 in the sleep state (e.g., such as while in the shutdown state of the battery pack) may be provided. The sub-processor 600 may be implemented to have the same or substantially the same internal processor structure and input/output terminals as those of the main processor 100, which may be implemented as an AFE IC, but considering that the sub-processor 600 functions as an auxiliary processor for waking up the main processor 100, it may be desirable to implement the sub-processor 600 as an integrated circuit (IC) to which low-consumption components are applied. Independently of the state of the main processor 100, the sub-processor 600 may remain in a woken state at all times, and a low-capacity built-in battery for supporting the operations of the sub-processor 600 may be applied to the sub-processor 600.

The main processor 100 woken up by the sub-processor 600 may operate the first protective element F1 when performing the protection operation to be described in more detail below, and may include the first switch SW1 as a driving element for operating the first protective element F1. In an example in which the first switch SW1 is implemented as a field-effect transistor (FET), the main processor 100 may turn on the first switch SW1 by applying a voltage signal to a gate terminal of the first switch SW1, and accordingly, because current flows to the first protective element F1 connected to a drain terminal of the first switch SW1, the first protective element F1 may operate.

The signals transmitted from the sub-processor 600 to the main processor 100 may include a wake-up signal SIG1 for waking up the main processor 100, and an abnormal state signal SIG2 that indicates that the voltage of the battery BAT is in an abnormal state. A signal arbitration circuit 700 may be provided to arbitrate inputs of the wake-up signal SIG1 and the abnormal state signal SIG2 from the sub-processor 600 to the main processor 100.

As shown in FIG. 2, the signal arbitration circuit 700 may include base paths 710 and 720, and first to third branch paths 701 to 703. As used herein, the current flowing in the base paths 710 and 720 is defined as a base current Ib, and currents flowing in the first to third branch paths 701 to 703 are defined as first to third branch currents I1 to I3, respectively.

The base paths 710 and 720 may be configured so that the base current Ib output from the sub-processor 600 flows to form the wake-up signal SIG1 and the abnormal state signal SIG2. FIG. 2 illustrates a structure in which two base paths 710 and 720 are connected to the output terminals of the sub-processor 600 to secure a redundancy, but in some embodiments, only one base path may be provided. The base paths 710 and 720 may include connection resistors R1 and R2 and diodes D1 and D2.

The first branch path 701 may branch from the base paths 710 and 720, and accordingly, the first branch current I1 that branches from the base current Ib may flow in the first branch path 701. A diode D3 and a connection resistor R3 may be provided in the first branch path 701, and a voltage formed in the connection resistor R3 by the first branch current I1 may be transmitted to the main processor 100 as the wake-up signal SIG1.

The second branch path 702 may branch from the base paths 710 and 720, and accordingly, the second branch current I2 that branches from the base current Ib may flow in the second branch path 702. A diode D4 may be provided in the second branch path 702. A second switch SW2 for forming the abnormal state signal SIG2 may be provided at an end of the second branch path 702 based on a direction in which the second branch current I2 flows. As an example in which the second switch SW2 is implemented as a FET, a gate terminal of the second switch SW2 may be connected to the second branch path 702, a source terminal may be grounded, and a drain terminal may be connected to an internal power supply V_{CC} (e.g., a BMS internal power supply, 3.3 V) through a connection resistor R4. Further, the gate terminal of the second switch SW2 may be connected to the source terminal through a connection resistor R5. Accordingly, because a gate-source voltage having a value greater than that of a threshold voltage of the second switch SW2 may be formed by the second branch current I2 and the connection resistor R5, the second switch SW2 may be turned on, a current may flow from the drain terminal to the source terminal, and a voltage formed at the drain terminal (e.g., a voltage across both ends (e.g., opposite ends) of the connection resistor R4 subtracted from a voltage of the internal power supply V_{CC}) may be transmitted to the main processor 100 as the abnormal state signal SIG2.

The third branch path 703 may branch from the base paths 710 and 720, and accordingly, the third branch current I3 that branches from the base current Ib may flow in the third branch path 703. A diode D5 may be provided in the third branch path 703. As shown in FIG. 2, the third branch current I3 may be combined at the same node N3 with the blocking signal SIG3 output from the main processor 100 to operate the second protective element F2. When a path to which the blocking signal SIG3 is input from the main processor 100 to the second protective element F2 is defined as a blocking signal path P2, a connection resistor R6 and a diode D6 may be provided in the blocking signal path P2, and a third switch SW3 for operating the second protective element F2 may be provided at an end of the blocking signal path P2 based on a direction in which the blocking signal SIG3 is applied to the second protective element F2. As an example in which the third switch SW3 is implemented as a FET, a gate terminal of the third switch SW3 may be connected to the blocking signal path P2, a source terminal may be grounded, and a drain terminal may be connected to the second protective element F2. Further, the gate terminal of the third switch SW3 may be connected to the source terminal through a connection resistor R7. Accordingly, as a gate-to-source voltage is formed by the current flowing through the blocking signal path P2 and the connection resistor R7 and the third switch SW3 is turned on, the current may flow to the second protective element F2, and thus, the second protective element F2 may operate.

Based on the above-described circuit structure, a configuration that allows the main processor 100 to recognize the disassembly status of the battery pack and the charging status of the battery BAT through the discharge path 400 to perform a consequent protection operation will be described in more detail hereinafter.

In the shutdown state of the battery pack, or in other words, in the sleep state of the main processor 100, the sub-processor 600 may monitor the voltage of the battery BAT, and may determine whether an abnormality has occurred or not in the voltage of the battery BAT based on the monitoring result. When a monitoring target is the battery cell, the sub-processor 600 may determine that the abnormality has occurred in the voltage of the battery cell when the monitored current voltage of the battery cell and a rated voltage of the battery cell (or in other words, a design voltage) are different from each other. An operation in which the sub-processor 600 monitors the voltage of the battery BAT may function as a preliminary operation for waking up the main processor 100, and the kind of abnormality in the battery voltage may be specified by the main processor 100.

When it is determined that the abnormality has occurred in the voltage of the battery BAT, the sub-processor 600 may form the wake-up signal SIG1 for waking up the main processor 100 and the abnormal state signal SIG2, which indicates that the voltage of the battery BAT is in the abnormal state. In this case, the sub-processor 600 may operate to output the base current Ib to the base paths 710 and 720 (e.g., which may also be referred to as an operation of forming a voltage (e.g., a set or predetermined voltage) at the output terminal of the sub-processor 600 to allow the base current Ib to flow in the base paths 710 and 720), and as the base current Ib branches through the first to third branch paths 701 to 703, the first to third branch currents I1 to I3 may respectively flow in the first to third branch paths 701 to 703.

As the first branch current I1 flows in the first branch path 701, the voltage formed in the connection resistor R3 provided in the first branch path 701 may be transmitted to the main processor 100 as the wake-up signal SIG1.

As the second branch current I2 flows in the second branch path 702, a gate-source voltage may be formed by the second branch current I2 and the connection resistor R5, and thus, the second switch SW2 may be turned on, the current may flow from the drain terminal to the source terminal, and the voltage formed at the drain terminal may be transmitted to the main processor 100 as the abnormal state signal SIG2.

The third branch path 703 may be combined with the blocking signal path P2 at the node N3. The third branch path 703 and the third branch current I3 will be described in more detail below.

The wake-up signal SIG1 and the abnormal state signal SIG2 formed through the sub-processor 600 and the signal arbitration circuit 700 may be transmitted to the main processor 100 in the sleep state. The main processor 100 may be woken up by the wake-up signal SIG1, and may operate to monitor the voltage of the battery BAT to determine the current status of the battery pack by specifying the kind of abnormality in the battery voltage after recognizing that the voltage of the battery BAT is in the abnormal state through the abnormal state signal SIG2. The kinds of abnormality in the battery voltage may be classified as a voltage abnormality due to the disassembly of the battery pack, and a voltage abnormality caused by the charging of the battery BAT through the discharge path 400.

First, when the monitored current voltage of the battery BAT satisfies a first voltage condition related to a voltage change, the main processor 100 may determine that the battery pack is in a disassembly process (e.g., the operation of the BMS itself assumes that the battery pack is in a state where it is possible to disassemble).

In order to determine 'the first voltage condition related to the voltage change', a voltage change amount of the battery BAT, which may be formed in a process of replacing the battery cell or battery module, may be defined or predefined in the main processor 100. For example, voltage change amounts caused in other battery cells or other battery modules when one or more battery cells or one or more battery modules are separated from the battery pack may be defined or predefined in the main processor 100, and values of the voltage change amounts may be designed based on a designer's experimental results for the disassembly of the battery pack.

Accordingly, the main processor 100 may determine that the first voltage condition is satisfied, and may determine that the battery pack is in a disassembled state when the current voltage of the battery BAT (e.g., the current voltage of the battery cell or the current voltage of the battery module) is in a state that varies by the voltage change amount, or corresponds to a state in which the current voltage of the battery BAT and the rated voltage differ from each other by the voltage change amount.

When it is determined that the battery pack is in the disassembled state, the main processor 100 may basically operate the first protective element F1 to block the current flow on the charge/discharge path 200, and accordingly, the battery pack and the BMS may be prevented from being reused.

In this case, the first voltage condition may be satisfied even in an initial manufacturing process of the battery pack, and in order to prevent a situation in which the use of the battery pack is prohibited by operating the first protective element F1 in the initial manufacturing process of the battery pack, when it is determined that the first voltage condition is satisfied, and thus, the battery pack is in the disassembled state, the main processor 100 may not immediately operate the first protective element F1, but may first verify a risk of the battery pack in the disassembled state (or in other words, when the current status of the battery pack in the disassembled state does not correspond to the initial manufacturing process), and then determine whether or not to perform the protection operation of the battery BAT depending on a verification result.

In an embodiment, battery management information may be adopted as information for verifying the risk of the battery pack, and the battery management information may include manufacturing date information of the battery pack generally stored in the main processor 100 (or a memory mounted in the main processor 100) in the initial manufacturing process of the battery pack. When the battery management information is already stored, the main processor 100 may determine that the battery pack in the disassembled state is in a dangerous state (or in other words, a state in which the battery pack has been disassembled after the battery pack was initially manufactured), and may perform the protection operation of the battery pack. On the other hand, when the battery management information is not already stored, the main processor 100 may determine that a current state of the battery pack is the disassembled state in the initial manufacturing process of the battery pack, and may not perform the protection operation of the battery pack. When the protection operation of the battery pack is performed as described above, the main processor 100 may operate the first protective element F1 to block the current flow on the charge/discharge path 200, and accordingly, the battery pack and the BMS may be prevented from being reused.

Next, when the monitored current voltage of the battery BAT satisfies a second voltage condition related to an overcharge state of the battery BAT, the main processor 100 may determine that the battery BAT is being charged by the charge current supplied through the discharge path 400. The configuration corresponds to detecting a situation in which the battery BAT is being charged by the charge current supplied through the discharge path 400 in 'the shutdown state of the battery pack', rather than detecting a situation in which the battery BAT is being charged by the charge current supplied through the discharge path 400 in an active state of the battery pack (or in other words, a normal operating state in which the main processor 100 is woken up).

In order to determine the 'second voltage condition related to the overcharge state of the battery BAT', a threshold voltage of the battery cell or a threshold voltage of the battery module for determining the overcharge state of the battery cell or the battery module may be defined or predefined in the main processor 100. Accordingly, when the current voltage of the battery BAT (e.g., the current voltage of the battery cell or the current voltage of the battery module) is greater than or equal to the threshold voltage, the main processor 100 may determine that the battery BAT is in the overcharge state as the battery BAT is being charged by the charge current supplied through the discharge path 400, and may block the current flow on the charge/discharge path 200 through the first protective element F1.

Independently of the operation of determining the battery overcharge state according to the second voltage condition, the main processor 100 may detect the overcharge state of the battery BAT in the active state of the battery pack. Referring to FIG. 1, when the battery BAT is overcharged in a state in which the charge current is supplied through the charge path 300 and the battery BAT is charged, the main processor 100 may turn off the charge control switch SW_C to block the flow of the charge current on the charge path 300, and when a short circuit defect occurs in the charge control switch SW_C, the main processor 100 may operate the second protective element F2 through the blocking signal SIG3 to block the current flow on the charge path 300.

In an embodiment, referring to FIG. 2, the signal arbitration circuit 700 is applied, and the third branch path 703 and the third branch current I3 of the signal arbitration circuit 700 may provide a topology in which the blocking signal SIG3 output from the main processor 100 may be implemented as a low current signal or a low voltage signal. Accordingly, a power consumption of the main processor 100 may be reduced.

In more detail, the third branch path 703 may be combined with the blocking signal path P2 at the node N3. Accordingly, a combined current formed by a current by the blocking signal SIG3 (or in other words, a current flowing through the connection resistor R6 and the diode D6) and the third branch current I3 combined at the node N3 flows toward the gate terminal of the third switch SW3. Because a gate-source voltage having a value greater than or equal to a threshold voltage of the third switch SW3 may be formed by the combined current and the connection resistor R7, the third switch SW3 is turned on, and accordingly, the second protective element F2 may operate to block the current flow on the charge path 300.

In other words, a topology capable of reducing the power consumption of the main processor 100 may be provided by implementing the current used to operate the second protective element F2 with the combined current of the current by the blocking signal SIG3 output from the main processor 100 and the third branch current I3 to reduce the magnitude of the blocking signal SIG3 output from the main processor 100 to operate the second protective element F2 by a magnitude of the third branch current I3. Accordingly, the signal arbitration circuit 700 including the first to third branch paths 701 to 703 may perform a function of arbitrating a signal transmission between the main processor 100 and the sub-processor 600, as well as a function of reducing the power consumption of the main processor 100.

### 3. Operating method of the battery device

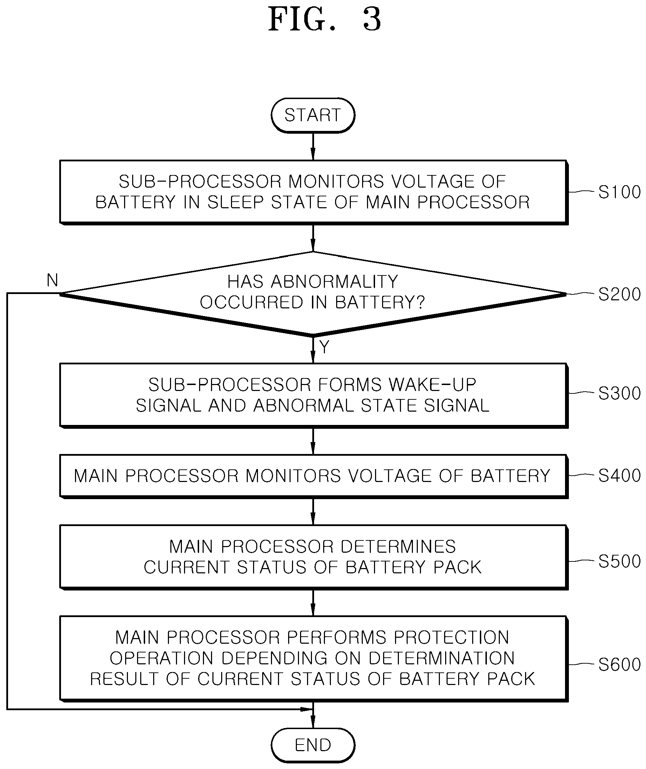

FIG. 3 is a flow chart of a method of operating the battery device according to an embodiment of the present disclosure. The operating method of the battery device according to an embodiment will be described in more detail with reference to FIG. 3. Hereinafter, redundant description as those described above may not be repeated, and a time-series configuration may be described in more detail.

Referring to FIG. 3, the method may start, and the sub-processor 600 may monitor the voltage of the battery BAT in a sleep state of the main processor 100 (S100).

The sub-processor 600 may determine whether or not an abnormality has occurred in the monitored voltage of the battery BAT (S200). In operation S200, the sub-processor 600 may determine that the abnormality has occurred (e.g., YES in S200) in the voltage of the battery BAT when the monitored voltage of the battery BAT and the rated voltage of the battery BAT are different from each other.

When it is determined that the abnormality has occurred in the voltage of the battery BAT (e.g., YES in operation S200), the sub-processor 600 may form a wake-up signal SIG1 for waking up the main processor 100, and an abnormal state signal SIG2, which indicates that the voltage of the battery BAT is in the abnormal state (S300).

Subsequently, the main processor 100 is woken up by the wake-up signal SIG1, and monitors the voltage of the battery BAT after recognizing that the voltage of the battery BAT is in the abnormal state through the abnormal state signal SIG2 (S400).

The main processor 100 determines a current status of the battery pack depending on the monitored voltage of the battery BAT (S500). The current status of the battery pack to be determined in operation S500 may correspond to a disassembly state of the battery pack, and a charge state of the battery BAT through the discharge path 400.

In operation S500, the main processor 100 determines that the battery pack is in the disassembled state when the monitored current voltage of the battery BAT satisfies a first voltage condition related to the voltage change, and determines that the battery BAT is being charged by the charge current supplied through the discharge path 400 when the monitored current voltage of the battery BAT satisfies a second voltage condition related to the overcharge state of the battery BAT.

After operation S500, the main processor 100 performs a protection operation depending on the determination result of the current status of the battery pack (S600), and the method may end.

When it is determined that the battery pack is in the disassembled state as the current voltage of the battery BAT satisfies the first voltage condition, in operation S600, the main processor 100 verifies a risk of the battery pack in the disassembled state using battery management information for managing the battery pack. The battery management information may include manufacturing date information of the battery pack, and accordingly, when the battery management information is already stored, the main processor 100 determines that the battery pack in the disassembled state is in a dangerous state, and blocks the current flow on the charge/discharge path 200 through the first protective element F1.

When it is determined that the battery BAT is being charged by the charge current supplied through the discharge path 400 as the current voltage of the battery BAT satisfies the second voltage condition, in operation S600, the main processor 100 immediately blocks the current flow on the charge/discharge path 200 through the first protective element F1.

Independently of operations S100 to S600, when the main processor 100 is in the overcharge state due to a short circuit defect in the charge control switch SW_C and the battery BAT is in the overcharge state, an operation of blocking the current flow on the charge path 300 by operating the second protective element F2 through the blocking signal SIG3 may be provided.

Thus, based on the structure in which the main processor that monitors the voltage of the battery BAT in the wake-up state and performs the protection operation of the battery pack depending on the monitoring result, and the sub-processor that monitors the voltage of the battery BAT in the sleep state of the main processor and wakes up the main processor depending on the monitoring result are provided in the battery pack, as the configuration in which the main processor switched from the sleep state to the wake-up state determines the current status of the battery BAT, and then performs the protection operation depending on the determination result is adopted, safety accidents of the battery pack due to the disassembly, modification, and reassembly of the battery pack and the charging of the battery pack through the discharge path may be effectively prevented.

The embodiments described herein may be implemented, for example, as a method or a process, a device, a software program, a data stream, or a signal. Although discussed in the context of an example implementation (e.g., such as a method), the features described herein may also be implemented in other suitable forms (e.g., a device or a program). The device may be implemented by any suitable hardware, software, firmware, and/or the like. The method may be implemented on a device, such as a processor that generally refers to a processing device including a computer, a microprocessor, an integrated circuit, a programmable logic device, and/or the like. The processor includes a communication device, such as a computer, a cell phone, a personal digital assistant (PDA), and/or other suitable devices that facilitate communication of information between the device and end-users.

According to some embodiments of the present disclosure, based on a structure in which a main processor (e.g., an analog front end integrated circuit (AFE IC)) that monitors a voltage of a battery in a wake-up state, and performs a protection operation of a battery pack depending on the monitoring result, and a sub-processor that monitors a voltage of the battery in a sleep state of the main processor, and wakes up the main processor depending on the monitoring result, are provided in the battery pack, a configuration in which the main processor that is switched from the sleep state to the wake-up state determines a current status of the battery pack (e.g., a situation of a disassembly, a modification, and a reassembly of the battery pack, or a situation of charging the battery pack through a discharge path), and then performs a protection operation depending on the determination result is provided, and thus, safety accidents of the battery pack due to the disassembly, modification, and reassembly of the battery pack and the charging of the battery pack through the discharge path may be effectively prevented.

However, the present disclosure is not limited to the above aspects and features.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

## Claims

1. A battery device comprising:
a main processor configured to monitor a voltage of a battery in a wake-up state, and perform a protection operation of a battery pack depending on a monitoring result; and
a sub-processor configured to monitor the voltage of the battery in a sleep state of the main processor, and generate a wake-up signal for waking up the main processor when an abnormality occurs in the voltage of the battery monitored by the sub-processor,
wherein the main processor is configured to be woken up by the wake-up signal, monitor the voltage of the battery, determine a current status of the battery pack depending on the voltage of the battery monitored by the main processor, and perform the protection operation depending on a determination result.

2. The battery device of claim 1, wherein:
the sub-processor is configured to generate an abnormal state signal indicating that the voltage of the battery is in an abnormal state along with the wake-up signal when the abnormality occurs in the voltage of the battery; and
the main processor is configured to be woken up by the wake-up signal, and monitor the voltage of the battery after recognizing that the voltage of the battery is in the abnormal state through the abnormal state signal.

3. The battery device of claim 2, wherein, when a current monitored voltage of the battery satisfies a first voltage condition related to a voltage change, the main processor is configured to determine that the battery pack is in a disassembled state.

4. The battery device of claim 3, wherein, when it is determined that the battery pack is in the disassembled state as the current monitored voltage of the battery satisfies the first voltage condition, the main processor is further configured to first verify a risk of the battery pack in the disassembled state using battery management information for managing the battery pack, and then determine whether or not to perform the protection operation of the battery depending on a verification result.

5. The battery device of claim 4, wherein:
the battery management information comprises manufacturing date information of the battery pack; and
the main processor is configured to determine that the battery pack in the disassembled state is in a dangerous state, and perform the protection operation of the battery pack when the battery management information is already stored.

6. The battery device of claim 5, further comprising a charge/discharge path for supplying a charge current to the battery and drawing a discharge current from the battery, the charge/discharge path comprising a first protective element configured to block a current flow,
wherein, when the protection operation of the battery pack is performed, the main processor is configured to block the current flow on the charge/discharge path through the first protective element.

7. The battery device of claim 6, further comprising:
a charge path branching from the charge/discharge path to supply a flow of the charge current to the battery; and
a discharge path branching from the charge/discharge path to draw a flow of the discharge current from the battery,
wherein the main processor is configured to monitor the voltage of the battery after recognizing that the voltage of the battery is in the abnormal state through the abnormal state signal, and determine that the battery is being charged by the charge current supplied through the discharge path when the current monitored voltage of the battery satisfies a second voltage condition related to an overcharge state of the battery.

8. The battery device of claim 7, wherein, when it is determined that the battery is being charged by the charge current supplied through the discharge path as the current monitored voltage of the battery satisfies the second voltage condition, the main processor is configured to block the current flow on the charge/discharge path through the first protective element.

9. The battery device of any of claims 2-8, further comprising a signal arbitration circuit configured to arbitrate transmission of the wake-up signal and the abnormal state signal from the sub-processor to the main processor.

10. The battery device of claim 9, wherein:
the signal arbitration circuit comprises a base path, and first and second branch paths branching from the base path;
a base current output from the sub-processor is configured to flow through the base path to form the wake-up signal and the abnormal state signal;
the wake-up signal is formed by a first branch current branching from the base current, and is configured to flow in the first branch path; and
the abnormal state signal is formed by a second branch current branching from the base current, and is configured to flow in the second branch path.

11. The battery device of claim 10, further comprising a charge path configured to flow the charge current supplied to the battery, the charge path comprising a charge control switch configured to regulate a flow of the charge current, and a second protective element configured to block the flow of the charge current when a defect occurs in the charge control switch,
wherein the main processor is configured to operate the second protective element through a blocking signal to block a current flow on the charge path in the wake-up state when the defect occurs in the charge control switch and the battery is in an overcharge state.

12. The battery device of claim 11, wherein:
the signal arbitration circuit further comprises a third branch path branching from the base path, the third branch path being configured to flow a third branch current branching from the base current; and
the blocking signal and the third branch current are configured to be combined with each other at the same node to operate the second protective element.

13. A method of operating a battery device comprising a sub-processor and a main processor, the method comprising:
monitoring, by the sub-processor, a voltage of a battery when the main processor is in a sleep state;
generating, by the sub-processor, a wake-up signal for waking up the main processor when an abnormality occurs in the voltage of the battery monitored by the sub-processor;
monitoring, by the main processor, the voltage of the battery after being woken up by the wake-up signal;
determining, by the main processor, a current status of a battery pack according to the voltage of the battery monitored by the main processor; and
performing, by the main processor, a protection operation depending on a determination result of the current status of the battery pack.

14. The method of claim 13, wherein:
in the generating, the sub-processor forms an abnormal state signal indicating that the voltage of the battery is in an abnormal state along with the wake-up signal when the abnormality occurs in the voltage of the battery; and
in the monitoring by the main processor, the main processor is woken up by the wake-up signal and monitors the voltage of the battery after recognizing that the voltage of the battery is in the abnormal state through the abnormal state signal.

15. The method of claim 14, wherein, in the determining, when a current voltage of the battery monitored by the main processor satisfies a first voltage condition related to a voltage change, the main processor determines that the battery pack is in a disassembled state.
